(19) **Europäisches Patentamt European Patent Office Office européen des brevets**

(11) **EP 2 058 669 B1**

(12) **EUROPEAN PATENT SPECIFICATION**

(45) Date of publication and mention
of the grant of the patent:
**27.06.2012 Bulletin 2012/26**

(51) Int Cl.:
***G01R 31/28*** *(2006.01)*

(21) Application number: **07425637.1**

(22) Date of filing: **12.10.2007**

(54) **A dynamic electric power supply unit that simulates an electric power source**

Dynamische Stromversorgungseinheit, die eine elektrische Stromquelle simuliert

Dispositif dynamique d'alimentation électrique servant à simuler une source d'alimentation électrique

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**13.05.2009 Bulletin 2009/20**

(73) Proprietor: **Power-One Italy S.p.a.**
**52028 Terranuova Bracciolini (AR) (IT)**

(72) Inventors:
- **Marcianesi, Andrea**
  **52100 Arezzo (IT)**
- **Martini, David, Ing.**
  **52027 S. Giovanni Valdarno, Arezzo (IT)**
- **Soldani, Simone**
  **52025 Levane, Arezzo (IT)**

(74) Representative: **Mannucci, Michele et al**
**Ufficio Tecnico Ing.A. Mannucci**
**Via della Scala 4**
**50123 Firenze (IT)**

(56) References cited:
**US-A1- 2005 051 209**

- **BYUNG-HWAN JEONG ET AL: "Virtual-implemented solar cell system with new cell model" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003, ANNUAL POWER ELECTRONICS SPECIALISTS CONFERENCE, NEW YORK, NY : IEEE, US, vol. VOL. 4 OF 4. CONF. 34, 15 June 2003 (2003-06-15), pages 736-740, XP010648901 ISBN: 0-7803-7754-0**

- **KULKARNI S S ET AL: "A novel PC based solar electric panel simulator" POWER ELECTRONICS AND DRIVE SYSTEMS, 2003. PEDS 2003. THE FIFTH INTERNATIONAL CONFERENCE ON SINGAPORE 17-20 NOV. 2003, PISCATAWAY, NJ, USA,IEEE, vol. 2, 17 November 2003 (2003-11-17), pages 848-852, XP010694262 ISBN: 0-7803-7885-7**

- **SANCHIS P ET AL: "Electronic converter for the analysis of photovoltaic arrays and inverters" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003, ANNUAL POWER ELECTRONICS SPECIALISTS CONFERENCE, NEW YORK, NY : IEEE, US, vol. VOL. 4 OF 4. CONF. 34, 15 June 2003 (2003-06-15), pages 1748-1753, XP010648559 ISBN: 0-7803-7754-0**

- **KOUTROULIS E ET AL: "Development of an FPGA-based System for Real-Time Simulation of" RAPID SYSTEM PROTOTYPING, 2006. SEVENTEENTH IEEE INTERNATIONAL WORKSHOP ON CHANIA, CRETE, GREECE 14-16 JUNE 2006, PISCATAWAY, NJ, USA,IEEE, 14 June 2006 (2006-06-14), pages 200-208, XP010919939 ISBN: 0-7695-2580-6**

- **CHAM YEW THEAN ET AL: "An Embedded Microchip System Design for Programmable Solar Panel Simulator" POWER ELECTRONICS AND DRIVES SYSTEMS, 2005. PEDS 2005. INTERNATIONAL CONFERENCE ON KUALA LUMPUR, MALAYSIA 28-01 NOV. 2005, PISCATAWAY, NJ, USA,IEEE, 28 November 2005 (2005-11-28), pages 1606-1610, XP010909904 ISBN: 0-7803-9296-5**

EP 2 058 669 B1

- MUKERJEE ET AL: "DC power supply used as photovoltaic simulator for testing MPPT algorithms" RENEWABLE ENERGY, PERGAMON PRESS, OXFORD, GB, vol. 32, no. 4, April 2007 (2007-04), pages 587-592, XP005714210 ISSN: 0960-1481
- LOPES L A C ET AL: "A simplified nonlinear power source for simulating PV panels" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003, ANNUAL POWER ELECTRONICS SPECIALISTS CONFERENCE, NEW YORK, NY : IEEE, US, vol. VOL. 4 OF 4. CONF. 34, 15 June 2003 (2003-06-15), pages 1729-1734, XP010648556 ISBN: 0-7803-7754-0
- ENRIQUE J M ET AL: "A new approach to obtain I-V and P-V curves of photovoltaic modules by using DC-DC converters" PHOTOVOLTAIC SPECIALISTS CONFERENCE, 2005. CONFERENCE RECORD OF THE THIRTY-FIRST IEEE LAKE BUENA VISTA, FL, USA 3-7 JAN. 2005, PISCATAWAY, NJ, USA,IEEE, US, 3 January 2005 (2005-01-03), pages 1769-1772, XP010823109 ISBN: 0-7803-8707-4
- JAE-HYUN YOO ET AL: "Analysis and control of PWM converter with V-I ouput characteristics of solar cell" INDUSTRIAL ELECTRONICS, 2001. PROCEEDINGS. ISIE 2001. IEEE INTERNATIONAL SYMPOSIUM ON JUNE 12-16, 2001, PISCATAWAY, NJ, USA,IEEE, vol. 2, 12 June 2001 (2001-06-12), pages 1049-1054, XP010548609 ISBN: 0-7803-7090-2
- SANCHIS P ET AL: "Electronic Controlled Device for the Analysis and Design of Photovoltaic Systems" IEEE POWER ELECTRONICS LETTERS, IEEE SERVICE CENTER, NEW YORK, NY, US, vol. 3, no. 2, June 2005 (2005-06), pages 57-62, XP011135639 ISSN: 1540-7985

## Description

Technical field

The present invention relates to the field of renewable power sources and more in particular to the design of electric power conditioning units for power generated by means of said renewable sources. Specifically, the present invention relates to an electric power source suitable to simulate a renewable energy source connectable to the input of an inverter, in particular a photovoltaic panel, an aerogenerator or another device for converting primary renewable energy into electric power.

State of the art

In order to tackle the problem of environmental pollution and the ever-increasing demand for electric power also for domestic use, the installation of distributed power generator sets is currently encouraged to supply loads of modest dimensions, for example in the field of residential dwellings and in commercial structures or in the industrial field. These generator sets use alternative energy sources, and in particular renewable sources, such as, in particular, solar energy using photovoltaic cells, forming photovoltaic panels or so-called photovoltaic fields, or wind power using aerogenerators. The latter typically have a rotor actuated by the wind and a generator that converts the mechanical energy collected on the axis of the rotor into electric energy.

Typically, an alternative energy source of this kind, which generates a direct current, is associated with a power-conditioning unit comprising at least one inverter. The inverter is connected in parallel to the electric-power-supply network or grid and/or to a local load, so that a generic local load can be supplied by the electrical network or by the inverter alternatively, or by both. When the power supplied by the alternative source is insufficient to supply the load, it is supplied either totally or in part by power drawn from the network. Instead, when the load absorbs less power than that available from the alternative source, or when the load is not supplied, the power generated by the alternative source is fed into the electricity network.

In certain cases, the alternative source is connected to a distribution network, to which only a load is connected and optionally a storage battery, but not the electric power supply network.

The energy source connected to the input of the inverter can be constituted by one or more photovoltaic panels. These can be connected to the network and to the load via converters that must perform substantially two functions. In the first place, they must ensure that when operating conditions vary, the maximum power possible is always extracted from the renewable source. In the second place, they must ensure that the current at the output of the converter is in phase with the network voltage. The first of the two functions is also defined as MPPT (Maximum Power Point Tracking).

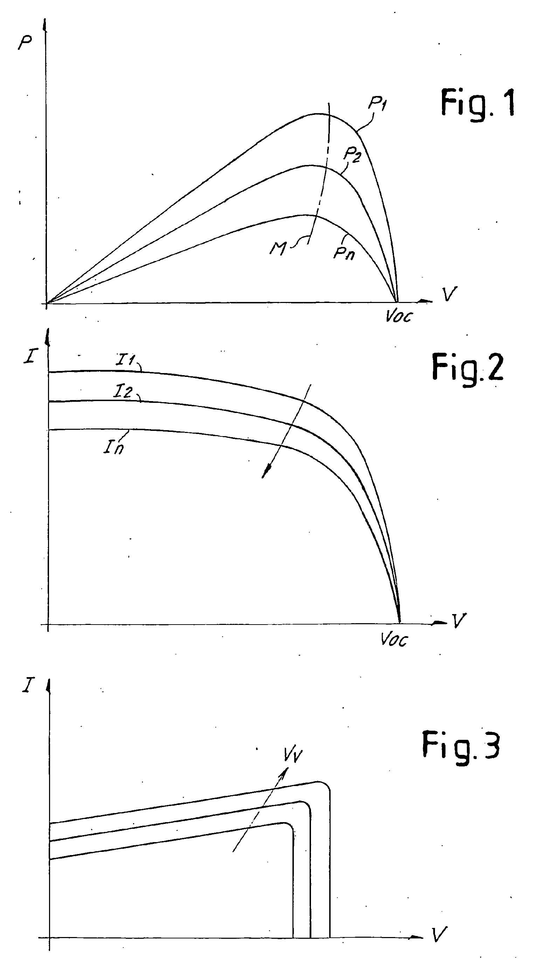

In fact, in the case of photovoltaic panels, for example, the power that can be extracted from the field of photovoltaic panels depends on the conditions of irradiation or insolation, i.e. on the amount of solar energy incident on the cells and is a function of the voltage applied across the field of photovoltaic panels itself and hence at the input of the converter. Figure 1 shows a diagram of the voltage-current characteristic of a typical field of photovoltaic panels, as well as the trend of the power that can be extracted from the field of photovoltaic panels (Ppv) for various conditions of solar irradiation when the voltage across the field of photovoltaic panels varies. The references P1, P2, ...Pn indicate the power curves as a function of the voltage V across the field of photovoltaic panels or photovoltaic field for different conditions of irradiation Irr. The curves P1, P2, ...Pn relate to a decreasing irradiation Irr. The reference I indicates the voltage-current characteristic of the field of photovoltaic panels.

From Figure 1 it can be seen that each curve Pi has a maximum that is characterized by voltages V progressively lower as the irradiation decreases. In other words, as the solar irradiation decreases - as is evident - the electric power that can be extracted from the field of photovoltaic panels also decreases and, moreover, the maximum power is obtained by making the field of photovoltaic panels operate at voltages that vary with temperature and irradiation. The reference M indicates the curve on which the maxima of the curves P1, P2, ... Pi, ... Pn are located.

The voltage-current curve of a photovoltaic field or panel also varies as a function of solar irradiation, i.e. of the power per surface unit received by the panel. Figure 2 illustrates by way of example the trend of a series of curves $I_1$, $I_2$, $I_n$ representative of the current supplied by the photovoltaic panel or field when the output voltage (indicated on the abscissa), i.e. the voltage at the input to the inverter, varies, for different values of solar irradiation. More in particular, the power per surface unit of the panel decreases as indicated by the arrow in Figure 2, passing from the curve $I_1$ to the curve $I_n$.

Electric power conditioning units that must be interfaced with a photovoltaic field or other renewable electric power source must be tested in conditions that reproduce the operating conditions, i.e. with an input source that behaves in the manner shown in the diagrams in Figures 1 and 2. In the case of high power inverters this is difficult, as a photovoltaic field of dimensions sufficient to generate the power required by this type of apparatus, which can reach even several tens of kW, is not always available.

Figure 3 indicates a family of voltage-current characteristic curves of an aerogenerator, when the speed of the wind Vv that turns the rotor of the generator varies. A trend analogous to that of the curves in Figure 2 can be seen.

US2005/0051209 discloses a system and a method for implementing virtual solar cells according to the preamble of claim 1. I$_n$ B.H. Jeong et al, *"Virtual-Implemented Solar Cells System with New cell Model"*, a model for solar cell is disclosed, for the reconstruction of the output of a photovoltaic system.

Objects and summary of the invention

According to one aspect, an object of the present invention is to provide a simulator of an electric source that allows the characteristics of a photovoltaic panel or other renewable energy source to be reproduced.

This object is achieved with a DC/DC power supply unit according to claim 1. Further advantageous features are set forth in the dependent claims.

In substance, according to a first aspect the invention relates to a DC/DC power supply unit for simulating an electric power source that has a voltage-current characteristic curve variable as a function of an external parameter, typically an uncontrollable external parameter such as irradiated solar power, wind speed or the like. The power supply unit comprises: a direct voltage source; a synthesis block of the characteristic curve; a feedback network that generates a control signal for a switch, as a function of an error signal obtained by comparing the current supplied by said power supply unit and a current value determined by said synthesis block of the characteristic curve.

The synthesis block of the characteristic curve is a block which, as a function of the output voltage of the power supply unit, generates a signal indicating the current or proportional to the current that said power supply unit must supply to follow the voltage-current characteristic curve of the source (photovoltaic panel, aerogenerator or other source supplied by renewable energy), the operation of which must be simulated by the power supply unit.

In an embodiment, for each voltage value output from the power supply unit, the synthesis block generates a current value corresponding substantially to the current value which, on said characteristic curve, corresponds to the voltage value output from the power supply unit. In practice, the current value can be a value approximated, for instance by interpolation. In fact, in a possible embodiment, current and voltage values belonging to at least one voltage current characteristic curve that characterizes the DC power source to be simulated by the power supply unit are stored in the synthesis block. The intermediate points of the curve are determined by linear interpolation, or by approximation by polynomials of higher degree.

To obtain correct operation of the power supply unit, the feedback network is advantageously designed so that the control signal that controls opening and closing of the electronic switch is independent from the output voltage of the power supply unit. This can be obtained, for instance, by combining the value of the feedback signal obtained by the control network with a (constant) voltage value of the direct voltage source and with the (variable) voltage value output from the power supply unit, i.e. the input voltage of the power conditioning unit (containing the inverter) applied to the power supply unit.

In an embodiment, the voltage source of the power supply unit has a voltage, which is equivalent to the open-circuit voltage of the photovoltaic panel or other source of alternative power to be simulated.

In an embodiment, the synthesis block is designed to simulate at least one characteristic curve of a photovoltaic panel, or preferably a plurality of characteristic curves of a photovoltaic panel, corresponding to different insolation conditions, i.e. to different power values per surface unit.

In an embodiment, the synthesis block can contain a series of stored data corresponding to a plurality of points of a characteristic curve, each point being defined by a voltage value and by a current value.

In an embodiment the synthesis block contains a series of stored data corresponding to a plurality of points of a characteristic curve, each point being defined by a voltage value and by a current value, said characteristic curve corresponding to a value of the external parameter (i.e. irradiation in the case of photovoltaic panels, or wind intensity in the case of aerogenerators). Moreover, the synthesis block determines the points of characteristic curves corresponding to different values of the external parameter multiplying the values of said characteristic curve by a constant parameter or coefficient, or by a parameter variable, for example, with the voltage.

With a power supply device of this type it is possible to perform tests on an inverter of a conditioning unit for conditioning the power generated by a photovoltaic panel, an aerogenerator or another source supplied by a renewable energy source, or by a system of fuel cells or the like.

This aspect is defined by the claim 10.

Brief description of the drawings

The invention will be better understood by following the description and accompanying drawing, which shows a non-limiting practical embodiment of the invention. More in particular, in the drawing:

Figure 1 shows a series of curves indicating the trend of the power generated by a photovoltaic field as a function of the output voltage when the solar irradiation, i.e. the irradiated power per surface unit, varies;

Figure 2 shows a series of current-voltage characteristic curves of a photovoltaic field when the solar irradiation varies;

Figure 3 shows a series of current-voltage characteristic curves of an aerogenerator when the wind intensity or speed varies;

Figure 4 shows a circuit diagram of a device according to the invention;

Figure 4A shows the circuit equivalent to the circuit in Figure 4;

Figure 5 shows a table representing the data stored for the synthesis of the characteristic curve; and

Figure 6 shows a diagram of a characteristic curve corresponding to the data in the table in Figure 5, and of a characteristic curve relative to a different irradiation condition, obtained by processing the former.

Detailed description of an embodiment of the invention

An embodiment, used for simulation of a photovoltaic panel, will be described in detail below. Nonetheless, it must be understood that the invention is not limited to this use, but can also be utilized in the simulation of sources of other types, such as an aerogenerator, with analogous problems relative to simulation of the characteristic curve when an external parameter varies.

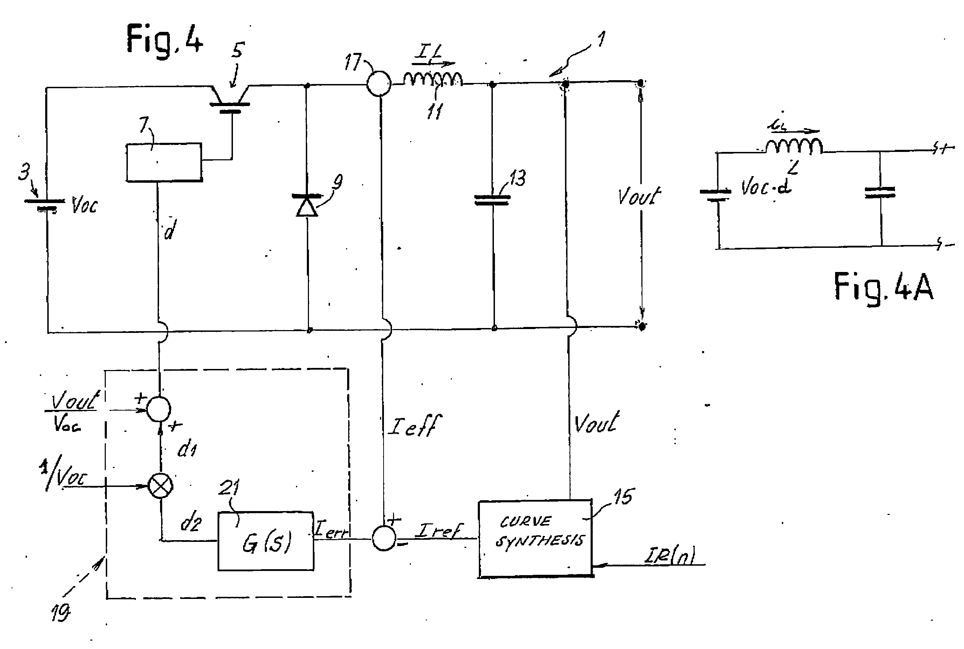

Figure 4 shows, indicated generically with 1, a current supply unit to be connected to the input of a power conditioning unit comprising an inverter, for example a photovoltaic inverter or other similar apparatus to be subjected to testing.

In an embodiment, the power supply unit has a step-down switching configuration and has a voltage source 3 generating a voltage $V_{oc}$, of a value corresponding substantially to the open circuit voltage of the photovoltaic panel or field, to which the inverter is to be connected. This is the voltage generated across the photovoltaic panel when it is disconnected from the load and at which, therefore, the panel does not supply current and power (see curves in Figures 1 and 2).

Reference number 5 indicates an electronic switch, controlled by means of a control circuit indicated schematically at 7, controlled with a duty cycle "d". The power supply unit 1 also comprises a diode 9, an inductance 11 and an output capacitor 13.

The power supply unit also comprises a block 15, hereinafter indicated as synthesis block of the characteristic curve of the solar panel. The input of this block receives a voltage signal $V_{out}$, which is a function of the output voltage of the power supply unit 1. This output voltage depends on the operating conditions of the inverter connected to the output of the power supply unit 1. The synthesis block 15 generates an output reference signal $I_{ref}$, which represents the value of the current supplied by a photovoltaic panel at a voltage $V_{out}$, said panel having a characteristic curve of the type shown in Figure 2. As the characteristic curve I-V of a photovoltaic panel changes when the power per surface unit irradiated on the panel varies, the input of the block 15 can even be supplied with a value proportional to the irradiated power per surface unit, as also this parameter can be significant in testing the inverter. In practice, this allows tests to be performed on the inverter in variable conditions of insolation or irradiation. This parameter is indicated with IR (n) in Figure 4, where (n) indicates that the value of this parameter can vary between a plurality of indicative values of different powers per surface unit.

The power supply unit 1 also comprises a current sensor 17 to detect the current flowing through the inductance 11. The signal $I_{ref}$ is subtracted from a signal $I_{eff}$ proportional to the current $i_L$ delivered from the circuit 1, to obtain an error signal $I_{eff}$ representative of the error between the current supplied by the power supply unit 1 and the current that should effectively correspond to the voltage $V_{out}$. The error signal $I_{err}$ is input to a feedback loop 19 with a feedback network 21.

The feedback signal generated by the feedback loop 19 must be such as to supply a control signal d independent from the voltage $V_{out}$. This is because the circuit 1 must simulate the behavior of the photovoltaic panel and, in order to perform simulation of the inverter connected to the panel, the voltage output $V_{out}$ from the panel applied to the inverter is set, while the current supplied by the simulation circuit 1 must follow the trend of the characteristic I-V as a function of the set value of $V_{out}$.

The independence of the control signal d from the value of $V_{out}$ is obtained by setting:

$$d = d_1 + \frac{V_{out}}{V_{OC}} \qquad (1)$$

where

$$d_1 = \frac{d_2}{V_{OC}} \qquad (2)$$

$d_2$ being the signal supplied by the feedback network 21. In fact, with reference to the circuit in Figure 3A, which represents the circuit equivalent to the circuit in Figure 3:

$$i_L = \frac{V_{OC}d - V_{out}}{sL} \qquad (3)$$

where

L is the value of the inductance 11
s is the variable of the transfer function of the feedback network 21.

By substituting in equation (3) the equations (1) and (2), the following is obtained

$$i_L = \frac{d_2}{sL} \qquad (4)$$

independent from the output voltage $V_{out}$.

Ultimately, therefore, the signal generated by the feedback network 21 on the basis of the error signal $I_{err}$ is divided by the open circuit voltage $V_{oc}$ of the photovoltaic panel that the power supply unit 1 must simulate and the ratio between the output voltage $V_{out}$ and the open circuit voltage $V_{oc}$ is added to the result of this division, obtaining a control signal d independent from $V_{out}$.

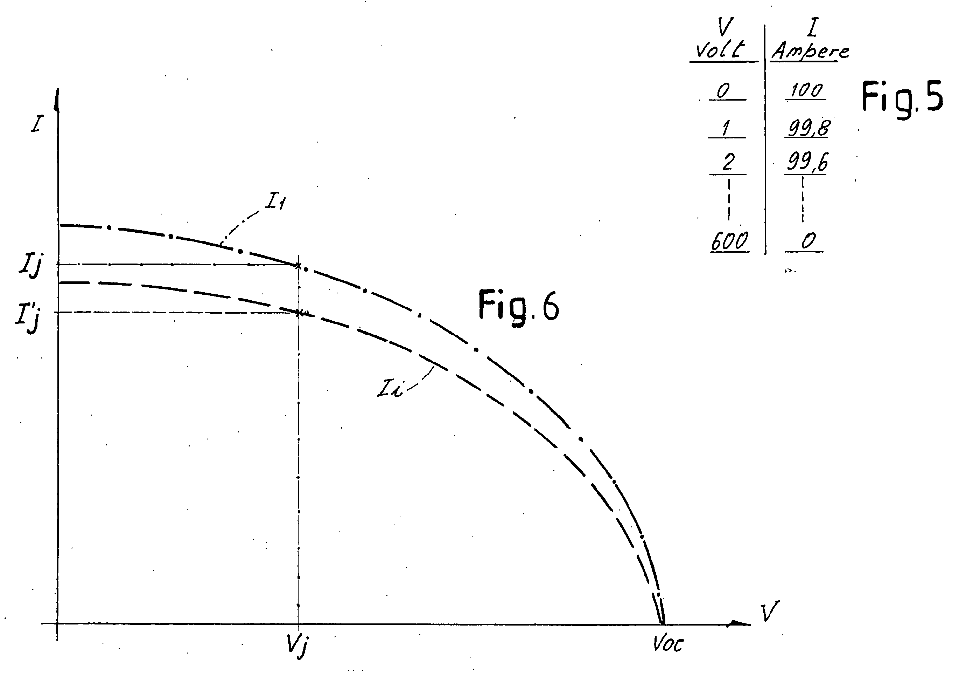

The block 15 can generate the signal $I_{ref}$ on the basis of a series of stored values, obtained experimentally from a photovoltaic panel of reference. For example, a series of pairs of values $(V_j; I_j)$, sufficiently close to allow reconstruction by interpolation, for example by a linear interpolation, of all the points of the curve I-V can be stored for each curve I-V. The block 15 works in this case by selecting the series of values $(V_j, I_j)$ relative to the curve I-V requested and providing, for each value of $V_{out}$ the corresponding value $I_{ref}$ obtained by interpolating the stored points $(V_j, I_j)$. Figure 5 represents in table form all the pairs of values of V and I defining a series of points belonging to one of the characteristic curves I-V. Figure 6 represents a characteristic curve I-V (curve $I_1$) obtained by interpolating various points defined by pairs of values $V_j, I_j$.

To reduce calculation costs and memory space required, increase the operating speed of the device and decrease the experimental measurements to be implemented on the photovoltaic panel of reference in order to collect an adequate number of values of V and I for an adequate number of curves corresponding to different irradiation values, according to a preferred embodiment of the invention the series of values $(V_j, I_j)$ of only one of the characteristic curves V-I, e.g. the one corresponding to the maximum irradiated power, is stored in the synthesis block 15. For different irradiation values, the current $I_{ref}$ is obtained by multiplying the current $I_{ref}$ relative to the maximum irradiation curve by a coefficient $k_i$ variable for each irradiation value. For a certain value of the irradiation, the coefficient or parameter $k_i$ can be fixed, i.e. invariant with respect to the variation of the voltage V. Nonetheless, according to a preferred embodiment, the coefficient or parameter $k_i$ is not constant, but is in turn a function of the voltage.

This criterion is clarified by the diagram in Figure 6. The reference $I_1$ indicates the characteristic curve representing the trend of the current as a function of the voltage for a specific value (e.g. the maximum value $IR_{max}$) of irradiation. As already stated, this curve is defined by pairs of values $V_j, I_j$ that define a series of points on said curve. The intermediate points can be obtained by linear interpolation or by any more complex approximation method.

The dashed and dotted line with the reference $I_i$ indicates the characteristic curve of the current as a function of the voltage for a value $IR_i$ lower than the value $IR_{max}$ to which the curve $I_1$ corresponds. The point $I_j;V_j$ on the curve $I_i$ is obtained by interpolation of the data $(V_j, I_j)$ stored in the block 15. Instead, the point $I'_j$ on the curve $I_i$ for the same value of voltage $V_j$ is given by:

$$I'_j = I_j * k_i$$

$k_i$ being the fixed parameter for each value of i. Or,

$$I'_j = I_j * k_i(v)$$

where $k_i(v)$ is a parameter or coefficient that varies for each curve (i.e. for each value of i) and along a specific curve also varies for each value of the voltage V.

It is understood that the drawing only shows a practical embodiment of the invention, which can vary in shapes and arrangements without however departing from the scope of the concept on which the invention is based. Any reference numbers in the appended claims are provided purely to facilitate reading of the claims in the light of the description above and of the accompanying drawings, and do not in any way limit the scope of protection represented by the claims.

**Claims**

1. A DC/DC power supply unit to simulate an electric energy source having a voltage-current characteristic curve variable as a function of an external parameter, comprising: a direct voltage source (3); a synthesis block (15) of said characteristic curve; a feedback loop (19) that generates a control signal (d) for a switch (5), as a function of an error signal ($I_{err}$) obtained from comparing the current ($I_L$) supplied by said power supply unit and a current value ($I_{ref}$) determined by said synthesis block (15) of the characteristic curve; wherein for each output voltage value ($V_{out}$) from said power supply unit, said synthesis block (15) generates said current value ($I_{ref}$) corresponding substantially to the current value which, on said characteristic curve, corresponds to the output voltage value ($V_{out}$) from the power supply unit; **characterized in that** said feedback loop (19) is designed such that the control signal (d) of said feedback loop (19) is made independent from the output voltage ($V_{out}$) of the power supply unit by combining the value of a feedback signal ($d_2$) obtained by a feedback network (21) with a voltage value ($V_{oc}$) of said direct voltage source (3) and with the output voltage value ($V_{out}$) of the power supply unit.

2. Power supply unit as claimed in claim 1, **character-**

**ized in that** the signal ($d_2$) generated by said feed-back network (21) on the basis of the error signal ($I_{err}$) is divided by the open circuit voltage ($V_{oc}$) of the electric energy source that the power supply unit (1) must simulate and the ratio between the output voltage ($V_{out}$) and the open circuit voltage ($V_{oc}$) is added to the result of said division, thus obtaining a control signal ($_d$) independent from the output voltage ($V_{out}$) of the power supply unit (1).

3. Power supply unit as claimed in claim 1 or 2, **characterized in that** said synthesis block is designed to simulate at least one characteristic curve of a photovoltaic panel.

4. Power supply unit as claimed in claim 3, **characterized in that** said synthesis block (15) is designed to simulate a plurality of characteristic curves of a photovoltaic panel, corresponding to a plurality of different insolation conditions of solar irradiation.

5. Power supply unit as claimed in claim 1, **characterized in that** said synthesis block (15) is designed to simulate at least one characteristic curve of an aerogenerator.

6. Power supply unit as claimed in claim 5, **characterized in that** said synthesis block is designed to simulate a plurality of characteristic curves of an aerogenerator, corresponding to a plurality of different wind speeds.

7. Power supply unit as claimed in one or more of the previous claims, **characterized in that** said synthesis block (15) contains a series of stored data corresponding to a plurality of points of a characteristic curve, each point being defined by a voltage value and by a current value.

8. Power supply unit as claimed in one or more of the previous claims, **characterized in that** said synthesis block (15) contains a series of stored data corresponding to a plurality of points of several characteristic curves, each point being defined by a voltage value and by a current value, and each curve corresponding to a different value of said external parameter.

9. Power supply unit as claimed in one or more of claims 1 to 7, **characterized in that** said synthesis block (15) contains a series of stored data corresponding to a plurality of points of a characteristic curve, each point being defined by a voltage value and by a current value, said characteristic curve corresponding to a value of said external parameter, and **in that** said synthesis block (15) determines the points of characteristic curves corresponding to different values of said external parameter by multiplying the values of said characteristic curve by one or more predetermined coefficients ($k_j$).

10. A method of performing tests on an inverter that converts a direct voltage input power into an alternating voltage output power, the phase and frequency of which is controlled, **characterized by** connecting a power supply unit (1) as claimed in one or more of the previous claims to the input of the inverter and by simulating with said power supply unit (1) the behavior of a source that generates an electric power subject to fluctuations as a function of said uncontrollable external parameter.

11. Method as claimed in claim 10, **characterized in that** it simulates, with said power supply, the behavior of a photovoltaic panel.

**Patentansprüche**

1. Gleichstrom/ Gleichstromspannungsversorgungseinheit zum Simulieren einer elektrischen Energiequelle mit einer Spannungs-Strom-Kennlinienvariablen als einer Funktion eines externen Parameters mit: einer Direktspannungsquelle (3), einem Syntheseblock (15) der Kennlinie, einer Rückkopplungsschleife (19), die ein Steuersignal (d) für einen Schalter (5) als eine Funktion eines Fehlersignals ($I_{err}$) erzeugt, das durch Vergleich des Stromes ($I_L$), der von der Spannungsversorgungseinheit geliefert wird, erhalten wird, und eines Stromwertes ($I_{ref}$), der durch den Syntheseblock (15) der Kennlinie bestimmt ist, wobei für jeden Ausgangsspannungswert ($V_{out}$) von der Spannungsversorgungseinheit der Syntheseblock (15) den Stromwert ($I_{ref}$) erzeugt, der im Wesentlichen dem Stromwert entspricht, der auf der Kennlinie dem Ausgangsspannungswert ($V_{out}$) von der Spannungsversorgungseinheit entspricht, **dadurch gekennzeichnet, dass** die Rückkopplungsschleife (19) so ausgelegt ist, dass das Steuersignal (d) der Rückkopplungsschleife (19) unabhängig gemacht wird von der Ausgangsspannung ($V_{out}$) der Spannungsversorgungseinheit durch Kombinieren des Wertes eines Rückkopplungssignals ($d_2$), das durch ein Rückkopplungsnetzwerk (21) erhalten wird, mit einem Spannungswert ($V_{cc}$) der Direktspannungsquelle (3) mit dem Ausgangsspannungswert ($V_{out}$) der Spannungsversorgungseinheit.

2. Spannungsversorgungseinheit nach Anspruch 1, **dadurch gekennzeichnet, dass** das Signal ($d_2$), das durch das Rückkopplungsnetzwerk (21) auf Grund des Fehlersignals ($I_{err}$) erzeugt wird, durch die Offenschaltungsspannung ($V_{oc}$) der elektrischen Energiequelle geteilt wird, die die Spannungsversorgungseinheit (1) simulieren muss, und wobei das Verhältnis zwischen der Ausgangsspannung ($V_{out}$) und der Offenschaltungsspannung ($V_{oc}$) dem Resultat der Division addiert wird, wodurch ein Steuersignal (d) unabhängig von der Ausgangsspannung ($V_{out}$) der Spannungsversorgungseinheit (1) erhalten wird.

3. Spannungsversorgungseinheit nach Anspruch 1 oder 2, **dadurch gekennzeichnet, dass** der Syntheseblock ausgelegt ist, zumindest eine Kennlinie eines Photovoltaikpaneels zu simulieren.

4. Spannungsversorgungseinheit nach Anspruch 3, **dadurch gekennzeichnet, dass** der Syntheseblock (15) ausgelegt ist, um eine Anzahl von Kennlinien eines Photovoltaikpaneels zu simulieren, die einer Anzahl von unterschiedlichen Einstrahlungsbedingungen von Sonnenstrahlung entsprechen.

5. Spannungsversorgungseinheit nach Anspruch 1, **dadurch gekennzeichnet, dass** der Syntheseblock (15) ausgelegt ist, um zumindest eine Kennlinie einer Windkraftanlage zu simulieren.

6. Spannungsversorgungseinheit nach Anspruch 5, **dadurch gekennzeichnet, dass** der Syntheseblock ausgelegt ist, um eine Anzahl von Kennlinien einer Windkraftanlage zu simulieren, die einer Anzahl von unterschiedlichen Windgeschwindigkeiten entsprechen.

7. Spannungsversorgungseinheit nach einem oder mehreren der vorstehenden Ansprüche, **dadurch gekennzeichnet, dass** der Syntheseblock (15) eine Reihe von gespeicherten Daten enthält, die eine Anzahl von Punkten einer Kennlinie entsprechen, wobei jeder Punkt durch einen Spannungswert und einen Stromwert definiert ist.

8. Spannungsversorgungseinheit nach einem oder mehreren der vorstehenden Ansprüche, **dadurch gekennzeichnet, dass** der Syntheseblock (15) einer Reihe von gespeicherten Daten entspricht, die einer Anzahl von Punkten von mehreren Kennlinien entsprechen, wobei jeder Punkt durch einen Spannungswert und einen Stromwert definiert ist und jede Kurve einem unterschiedlichen Wert des externen Parameters entspricht.

9. Spannungsversorgungseinheit nach einem oder mehreren der Ansprüche 1 bis 7, **dadurch gekennzeichnet dass** der Syntheseblock (15) eine Reihe von gespeicherten Daten enthält, die eine Anzahl von Punkten einer Kennlinie entsprechen, wobei jeder Punkt durch einen Spannungswert und einen Stromwert definiert ist, wobei die Kennlinie einem Wert des externen Parameters entspricht und dass der Syntheseblock (15) die Punkte der Kennlinien bestimmt, die unterschiedlichen Werten des externen Parameters entsprechen, durch Multiplizieren der Werte der Kennlinie mit einem oder mehreren Koeffizienten ($k_j$).

10. Verfahren des Testens eines Inverters, der eine Gleichspannungseingangsleistung in eine Wechselausgangsleistung wandelt, deren Phase und Frequenz gesteuert werden, **gekennzeichnet durch** Verbinden einer Spannungsversorgungseinheit (1) nach einem oder mehreren der vorstehenden Ansprüche mit dem Eingang des Inverters und **durch** Simulieren mit der Spannungsversorgungseinheit (1) des Verhaltens der Quelle, die eine elektrische Leistung erzeugt, die Fluktuationen als eine Funktion des nichtsteuerbaren externen Parameters ausgesetzt ist.

11. Verfahren nach Anspruch 10, **dadurch gekennzeichnet, dass** es mit der Spannungsversorgungseinheit das Verhalten eines Photovoltaikpaneels simuliert.

## Revendications

1. Unité d'alimentation électrique CC/CC pour simuler une source d'énergie électrique possédant une courbe caractéristique de tension-courant variable en fonction d'un paramètre externe, comprenant : une source de tension continue (3) ; un bloc de synthèse (15) de ladite courbe caractéristique ; une boucle de rétroaction (19) qui génère un signal de commande (d) pour un commutateur (5), en fonction d'un signal d'erreur ($I_{err}$) obtenu à partir de la comparaison du courant ($I_L$) fourni par ladite unité d'alimentation électrique et une valeur de courant ($I_{ref}$) déterminée par ledit bloc de synthèse (15) de la courbe caractéristique ; dans laquelle, pour chaque valeur de tension de sortie ($V_{out}$) à partir de ladite unité d'alimentation électrique, ledit bloc de synthèse (15) génère ladite valeur de courant ($I_{ref}$) correspondant sensiblement à la valeur de courant qui, sur ladite courbe caractéristique, correspond à la valeur de tension de sortie ($V_{out}$) à partir de l'unité d'alimentation électrique ; **caractérisée en ce que** ladite boucle de rétroaction (19) est conçue de sorte que le signal de commande (d) de ladite boucle de rétroaction (19) soit réalisé indépendamment de la tension de sortie ($V_{out}$) de l'unité d'alimentation électrique en combinant la valeur d'un signal de rétroaction ($d_2$) obtenue par un réseau de rétroaction (21) avec une valeur de tension ($V_{oc}$) de ladite source de tension continue (3) et avec la valeur de tension de sortie ($V_{out}$) de l'unité d'alimentation électrique.

2. Unité d'alimentation électrique selon la revendication 1, **caractérisée en ce que** le signal ($d_2$) généré

par ledit réseau de rétroaction (21) en fonction du signal d'erreur ($I_{err}$) est divisé par la tension en circuit ouvert ($V_{oc}$) de la source d'énergie électrique que l'unité d'alimentation électrique (1) doit simuler et le rapport entre la tension de sortie ($V_{out}$) et la tension en circuit ouvert ($V_{oc}$) est ajouté au résultat de ladite division, obtenant ainsi un signal de commande (d) indépendant de la tension de sortie ($V_{out}$) de l'unité d'alimentation électrique (1).

3. Unité d'alimentation électrique selon la revendication 1 ou 2, **caractérisée en ce que** ledit bloc de synthèse est conçu pour simuler au moins une courbe caractéristique d'un panneau photovoltaïque.

4. Unité d'alimentation électrique selon la revendication 3, **caractérisée en ce que** ledit bloc de synthèse (15) est conçu pour simuler une pluralité de courbes caractéristiques d'un panneau photovoltaïque, correspondant à une pluralité de différentes conditions d'insolation de rayonnement solaire.

5. Unité d'alimentation électrique selon la revendication 1, **caractérisée en ce que** ledit bloc de synthèse (15) est conçu pour simuler au moins une courbe caractéristique d'un aérogénérateur.

6. Unité d'alimentation électrique selon la revendication 5, **caractérisée en ce que** ledit bloc de synthèse est conçu pour simuler une pluralité de courbes caractéristiques d'un aérogénérateur, correspondant à une pluralité de différentes vitesses du vent.

7. Unité d'alimentation électrique selon une ou plusieurs des revendications précédentes, **caractérisée en ce que** ledit bloc de synthèse (15) contient une série de données stockées correspondant à une pluralité de points d'une courbe caractéristique, chaque point étant défini par une valeur de tension et par une valeur de courant.

8. Unité d'alimentation électrique selon une ou plusieurs des revendications précédentes, **caractérisée en ce que** ledit bloc de synthèse (15) contient une série de données stockées correspondant à une pluralité de points de plusieurs courbes caractéristiques, chaque point étant défini par une valeur de tension et par une valeur de courant, et chaque courbe correspondant à une valeur différente dudit paramètre externe.

9. Unité d'alimentation électrique selon une ou plusieurs des revendications 1 à 7, **caractérisée en ce que** ledit bloc de synthèse (15) contient une série de données stockées correspondant à une pluralité de points d'une courbe caractéristique, chaque point étant défini par une valeur de tension et par une valeur de courant, ladite courbe caractéristique correspondant à une valeur dudit paramètre externe ; et **en ce que** ledit bloc de synthèse (15) détermine les points de courbes caractéristiques correspondant à des valeurs différentes dudit paramètre externe en multipliant les valeurs de ladite courbe caractéristique par un ou plusieurs coefficients prédéterminés ($k_i$).

10. Procédé de réalisation d'essais sur un onduleur qui convertit une puissance d'entrée à tension continue en une puissance de sortie à tension alternative, dont la phase et la fréquence sont commandées, **caractérisé par** la connexion d'une unité d'alimentation électrique (1) selon une ou plusieurs des revendications précédentes à l'entrée de l'onduleur et par la simulation avec ladite unité d'alimentation électrique (1) du comportement d'une source qui génère une puissance électrique suivant des fluctuations en fonction dudit paramètre externe incontrôlable.

11. Procédé selon la revendication 10, **caractérisé en ce qu'**il simule, avec ladite alimentation électrique, le comportement d'un panneau photovoltaïque.

Fig. 1

Fig. 2

Fig. 3

Fig.4A

Fig.4

Fig.5

| V volt | I Ampere |
|--------|----------|
| 0 | 100 |
| 1 | 99,8 |
| 2 | 99,6 |
| ¦ | ¦ |
| 600 | 0 |

Fig.6

EP 2 058 669 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050051209 A